# EUROPEAN PATENT APPLICATION

(11) **EP 4 665 098 A1**
(43) Date of publication of application: **17.12.2025**
(21) Application number: 24755874.5
(22) Date of filing: 16.01.2024
(51) Int. Cl.: H05K 7/20

(54) **PHOTOVOLTAIC INVERTER AND POWER DEVICE**

(30) Priority: 13.02.2023 CN 202310155930
(71) Applicant: Huawei Digital Power Technologies Co., Ltd., Shenzhen, Guangdong 518043 (CN)
(72) Inventor: LI, Maofan, Shenzhen, Guangdong 518043 (CN); FAN, Guohua, Shenzhen, Guangdong 518043 (CN); WU, Kai, Shenzhen, Guangdong 518043 (CN)
(74) Representative: Isarpatent
(86) International application number: PCT/CN2024/072625
(87) International publication number: WO 2024/169499

(57) **Abstract**

This application relates to the field of heat dissipation technologies, and in particular, to a photovoltaic inverter and a power apparatus. The photovoltaic inverter includes a heat sink and a power module. The heat sink includes a bottom case and a top case that are disposed opposite to each other, and the bottom case and the top case can enclose a heat dissipation cavity. The heat dissipation cavity is configured to accommodate a cooling medium. The bottom case includes a window, and the window penetrates the bottom case. The power module is fastened to a surface that is of the bottom case and that faces away from the heat dissipation cavity, and an orthographic projection of the power module on the bottom case overlaps an orthographic projection of the window on the bottom case, so that the power module may be in contact with the cooling medium in the heat dissipation cavity through the window. The power module of the photovoltaic inverter may be in contact with the cooling medium in the heat dissipation cavity of the heat sink through the window, so that a thermally conductive intermediary is not required, and direct-cooling heat dissipation of the power module may be implemented, thereby improving heat dissipation efficiency.

## Description

### CROSS-REFERENCE TO RELATED APPLICATIONS

This application claims priority to Chinese Patent Application No. 202310155930.3, filed with the China National Intellectual Property Administration on February 13, 2023 and entitled "PHOTOVOLTAIC INVERTER AND POWER APPARATUS", which is incorporated herein by reference in its entirety.

### TECHNICAL FIELD

This application relates to the field of heat dissipation technologies, and in particular, to a photovoltaic inverter and a power apparatus.

### BACKGROUND

An inverter is a converter that converts direct current energy into an alternating current with a fixed frequency and a fixed voltage or with a variable frequency and a variable voltage. With the development of science and technology, a power module of the inverter needs to have a higher power density, lower costs, and a longer service life to adapt to social development and improve industrial efficiency. As the power density of the power module of the inverter increases, a requirement for a heat dissipation capability of the power module also increases synchronously.

Generally, a heat sink is used to dissipate heat for the power module, and specifically, a thermally conductive intermediary is used to perform heat conduction between the power module and the heat sink. This heat conduction manner has relatively low heat conduction efficiency that is difficult to improve, and becomes a bottleneck for improving a heat dissipation capability of the inverter currently.

### SUMMARY

This application provides a photovoltaic inverter and a power apparatus, to implement direct-cooling heat dissipation, thereby improving heat dissipation efficiency.

According to a first aspect, this application provides a photovoltaic inverter. The photovoltaic inverter may be configured to convert an alternating current of a solar panel into a direct current for power supply. The photovoltaic inverter includes a heat sink and a power module, and the heat sink is configured to dissipate heat for the power module. The heat sink includes a bottom case and a top case that are disposed opposite to each other, and the bottom case and the top case can enclose a heat dissipation cavity. The heat dissipation cavity is configured to accommodate a cooling medium, and the cooling medium may dissipate heat for the power module in a liquid-cooling heat dissipation manner. The bottom case includes a window, and the window penetrates the bottom case, so that the heat dissipation cavity can communicate with the outside through the window. The power module is fastened to a surface that is of the bottom case and that faces away from the heat dissipation cavity. Specifically, the power module is mounted at a position at which the window is disposed on the bottom case, and an orthographic projection of the power module on the bottom case overlaps an orthographic projection of the window on the bottom case, so that the power module may be in contact with the cooling medium in the heat dissipation cavity through the window. The power module of the photovoltaic inverter may be in contact with the cooling medium in the heat dissipation cavity of the heat sink through the window, so that a thermally conductive intermediary is not required, and direct-cooling heat dissipation of the power module may be implemented, thereby improving heat dissipation efficiency.

The power module includes a substrate and a power device. The power device is fastened to the substrate, and the substrate is configured to be fastened to the bottom case of the heat sink. When the power module is fastened to the heat sink, the power device is located on a surface that is of the substrate and that faces away from the heat sink. Heat emitted by the power device may be transferred to the cooling medium through the substrate. In one power module, one power device may be disposed on the substrate, or a plurality of power devices may be disposed on the substrate.

In the power module, the substrate can provide bearing and function implementation for the power device, and an orthographic projection of the power device on the substrate is located on a surface that is basically away from the heat sink.

In some possible implementations, the photovoltaic inverter includes an annular adapter enclosure frame, and the power module is fastened to the bottom case by using the annular adapter enclosure frame. A surface that is of the annular adapter enclosure frame and that faces the heat dissipation cavity is configured to be fastened to the bottom case, and the other surface that is of the annular adapter enclosure frame and that faces away from the heat dissipation cavity is configured to be fastened to the power module. Possibly, a material of the annular adapter enclosure frame may include copper, stainless steel, or a copper-aluminum composite material, a material of the substrate may include copper or a copper alloy, and a material of the bottom case may include aluminum or an aluminum alloy. Specifically, the annular adapter enclosure frame is welded to the power module, and the annular adapter enclosure frame is welded to a surface that is of the enclosure and on which the window is disposed. In this connection manner, the annular adapter enclosure frame is used as a transition of a welding process. The annular adapter enclosure frame and the bottom case may be first welded together, and then the power module is welded to the annular adapter enclosure frame. A welding process between the annular adapter enclosure frame and the bottom case may include laser welding, friction stir welding, and brazing, and a welding process between the annular adapter enclosure frame and the power module may include laser welding. With the use of the annular adapter enclosure frame, the annular adapter enclosure frame, the power module, and the bottom case of the heat sink may be welded together by using different welding processes, thereby resolving a technical problem that failure of the power module is caused by a very high temperature or excessive deformation under stress during one-time copper-aluminum welding.

After the power module is fastened to the bottom case by using the annular adapter enclosure frame, the orthographic projection of the window on the bottom case is located in a projection range of an outer edge of the annular adapter enclosure frame on the bottom case, and an orthographic projection of the substrate on the bottom case covers an orthographic projection of an inner edge of the annular adapter enclosure frame on the bottom case. The annular adapter enclosure frame can provide good support for the power module and can be securely fastened to the bottom case.

In a possible implementation, a first stepped surface is disposed on a surface that is of the annular adapter enclosure frame and that faces away from the heat sink. The first stepped surface is located on an inner surface side of the annular adapter enclosure frame, so that the first stepped surface may be configured to fasten the power module. The first stepped surface includes a first inner wall, a second inner wall, and a first connection wall connected between the first inner wall and the second inner wall. A projection of the second inner wall on the bottom case is located in a projection range of the first inner wall on the bottom case. The substrate is welded to the first connection wall. A depth of the first inner wall of the annular adapter enclosure frame is set, so that the surface that is of the annular adapter enclosure frame and that faces away from the heat sink may be coplanar with the surface that is of the substrate and that faces away from the heat sink, and a joint between the annular adapter enclosure frame and the substrate may be kept flat.

Possibly, a second stepped surface is disposed on the surface that is of the annular adapter enclosure frame and that faces away from the heat sink. The second stepped surface is located on an outer edge side of the annular adapter enclosure frame, so that the second stepped surface may be configured to match the surface that is of the bottom case and that faces away from the heat dissipation cavity. The second stepped surface includes a first outer wall, a second outer wall, and a third connection wall connected between the first outer wall and the second outer wall. A projection of the second outer wall on the enclosure is located in a projection range of the first outer wall on the bottom case. The third connection wall is coplanar with the surface that is of the bottom case and that faces away from the heat dissipation cavity, so that a joint between the annular adapter enclosure frame and the bottom case may be kept flat.

In some possible implementations, the power module is directly welded to the bottom case. A material of the substrate may include a copper-aluminum composite material or a copper-steel composite material, a material of the bottom case may include aluminum or an aluminum alloy, and the substrate of the power module is welded to the bottom case.

A projection of the substrate on the bottom case covers a projection of the window on the bottom case. When the substrate is welded to the bottom case, the substrate may block the window, so that the substrate can be directly in contact with the cooling medium in the heat dissipation cavity through the window.

In some possible implementations, the bottom case includes a first groove, and the first groove includes a groove side wall and a groove bottom. The window is disposed at the groove bottom. The orthographic projection of the power module on the bottom case is located in an orthographic projection range of the first groove on the bottom case. When the power module is fastened to the bottom case by using the annular adapter enclosure frame, the first groove may be configured to accommodate the annular adapter enclosure frame, and the groove bottom is coplanar with a surface that is of the annular adapter enclosure frame and that faces the heat sink. When the power module is directly fastened to the bottom case, the first groove may be configured to accommodate the substrate.

In some possible implementations, a second groove is disposed on a surface that is of the top case of the heat sink and that faces away from the heat dissipation cavity. A projection of the second groove on the top case is located between orthographic projections of two adjacent power modules on the top case. The second groove may reduce a weight of the heat sink, and does not affect structural strength and stability of the heat sink.

To facilitate circulation of the cooling medium into the heat dissipation cavity of the heat sink, a liquid inlet and a liquid outlet are disposed on the top case of the heat sink. The liquid inlet and the liquid outlet separately penetrate the top case, so that the heat dissipation cavity communicates with the outside. During working, the cooling medium with a relatively low temperature may be transferred to the heat dissipation cavity through the liquid inlet, and the cooling medium in the heat dissipation cavity may be discharged through the liquid outlet after absorbing, through the substrate, heat emitted by the power device, thereby implementing circulation of the cooling medium.

In some possible implementations, the photovoltaic inverter includes a plurality of power modules. The bottom case correspondingly includes a plurality of windows. The plurality of windows are spaced apart, and the plurality of power modules are in a one-to-one correspondence with the plurality of windows. The plurality of power modules may be in contact with the cooling medium respectively through the corresponding windows, thereby improving heat dissipation uniformity.

According to a second aspect, this application provides a power apparatus. The power apparatus includes but is not limited to an in-vehicle power unit, a power conversion module, or the like. The power apparatus includes a power conversion circuit, a housing, and a heat sink. The power conversion circuit herein includes a plurality of power modules and a plurality of components. The housing and the heat sink enclose an accommodating cavity, and the accommodating cavity may be configured to accommodate the power conversion circuit. The heat sink includes a bottom case and a top case that are disposed opposite to each other, and the bottom case and the top case enclose a heat dissipation cavity. The heat dissipation cavity is configured to accommodate a cooling medium. A plurality of windows are disposed on the case, and each window penetrates the bottom case, so that the heat dissipation cavity may communicate with the outside through the windows. The plurality of power modules are fastened to the bottom case, and the plurality of power modules are in contact with the cooling medium through the plurality of windows that are in a one-to-one correspondence with the plurality of power modules. In the power apparatus, similar to the foregoing photovoltaic inverter, the power module in the power conversion circuit is directly fastened to the heat sink, and the power module is enabled to be in contact with the cooling medium in the heat dissipation cavity of the heat sink through the window, so that a thermally conductive intermediary is not required, and direct-cooling heat dissipation of the power module may be implemented, thereby improving heat dissipation efficiency.

### BRIEF DESCRIPTION OF DRAWINGS

FIG. 1 shows a heat dissipation principle of an inverter in a conventional technology;
FIG. 2 is a diagram of a structure of a photovoltaic inverter according to an embodiment of this application;
FIG. 3a is a diagram of a structure of a heat sink in a photovoltaic inverter according to an embodiment of this application;
FIG. 3b is a diagram of a cross-sectional structure of Q1-Q1 in FIG. 3a;
FIG. 3c is an enlarged view of W1 in FIG. 3b;
FIG. 4 is an exploded view of a photovoltaic inverter according to an embodiment of this application;
FIG. 5a is a diagram of a structure of an annular adapter enclosure frame in a photovoltaic inverter according to an embodiment of this application;
FIG. 5b is a diagram of a cross-sectional structure of Q2-Q2 in FIG. 5a;
FIG. 6a is a diagram of a structure of an annular adapter enclosure frame in a photovoltaic inverter according to an embodiment of this application;
FIG. 6b is a diagram of a cross-sectional structure of Q3-Q3 in FIG. 6a;
FIG. 7a is a diagram of a structure in which an annular adapter enclosure frame is mounted to a heat sink in a photovoltaic inverter according to an embodiment of this application;
FIG. 7b is a diagram of a cross-sectional structure of Q4-Q4 in FIG. 7a;
FIG. 7c is an enlarged view of W2 in FIG. 7b;
FIG. 8a is a diagram of a cross-sectional structure of a photovoltaic inverter according to an embodiment of this application;
FIG. 8b is an enlarged view of W3 in FIG. 8a;
FIG. 9a is a diagram of a structure of a sectioned photovoltaic inverter according to an embodiment of this application;
FIG. 9b is a diagram of a structure of a sectioned photovoltaic inverter according to an embodiment of this application;
FIG. 10 is an exploded view of a photovoltaic inverter according to an embodiment of this application;
FIG. 11a is a diagram of a structure of a power module in a photovoltaic inverter according to an embodiment of this application;
FIG. 11b is a diagram of a cross-sectional structure of Q5-Q5 in FIG. 11a;
FIG. 12a is a diagram of a cross-sectional structure of a photovoltaic inverter according to an embodiment of this application;
FIG. 12b is an enlarged view of W4 in FIG. 12a;
FIG. 13 is an exploded view of a power apparatus according to an embodiment of this application; and
FIG. 14 is a diagram of a cross-sectional structure of a power apparatus according to an embodiment of this application.

### DESCRIPTION OF EMBODIMENTS

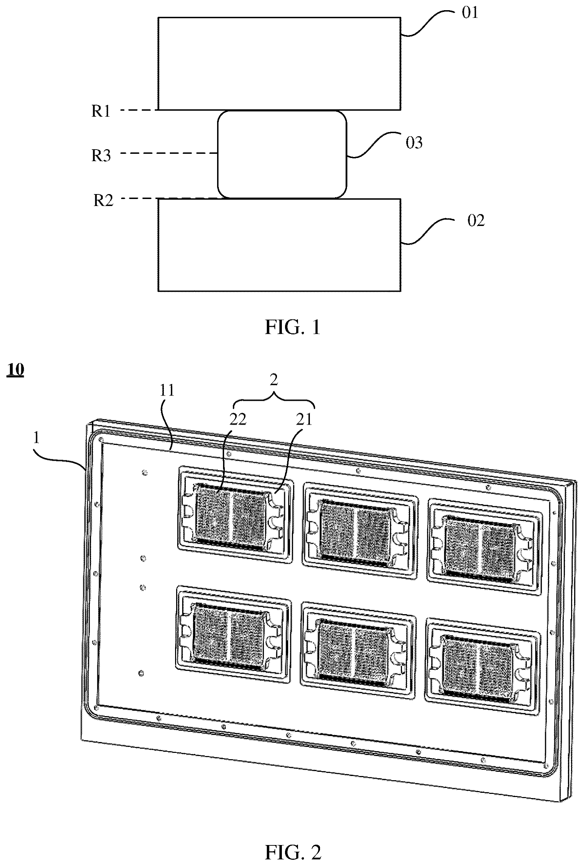

An inverter may convert a direct current into an alternating current. For example, a photovoltaic inverter is an inverter that may convert a variable direct current generated by a photovoltaic solar panel into an alternating current with a mains frequency. The direct current obtained through conversion by the photovoltaic inverter may be fed back to a commercial power transmission system or used by an off-grid power system. As a power density of the inverter continuously increases, heat consumption of an electronic device in the inverter also increases sharply. Therefore, how to resolve a heat dissipation problem of the inverter is particularly important. FIG. 1 shows a working principle of heat dissipation of an existing inverter. As shown in FIG. 1, the inverter includes a power module 01 and a heat sink 02. The power module 01 is equivalent to a heat source, and the heat sink 02 is configured to dissipate heat for the power module 01. A thermally conductive intermediary 03 is disposed between the power module 01 and the heat sink 02, and the thermally conductive intermediary 03 is configured to conduct heat emitted by the power module 01 to the heat sink 02. The heat sink 02 may dissipate heat in a manner of liquid cooling, air cooling, or the like. There is first interfacial thermal resistance R1 between the thermally conductive intermediary 03 and the power module 01, and there is second interfacial thermal resistance R2 between the thermally conductive intermediary 03 and the heat sink 02. In addition, there is thermal resistance R3 in the thermally conductive intermediary 03. Total thermal resistance in a heat dissipation link of the inverter includes the first interfacial thermal resistance R1, the second interfacial thermal resistance R2, and the thermal resistance R3. The total thermal resistance causes low heat conduction efficiency of the photovoltaic inverter, and heat dissipation efficiency cannot be greatly improved. The thermally conductive intermediary 03 may include but is not limited to thermally conductive silicone, a thermally conductive pad, a thermally conductive gel, or the like. In addition, the foregoing interfacial thermal resistance means that when a heat flow passes through an interface, because a lattice periodicity at the interface is interrupted, hot carriers cannot all pass through the interface, and an interfacial temperature difference is formed on both sides of the interface. A ratio of the interfacial temperature difference to a heat flow density is referred to as contact interfacial thermal resistance. The interface includes a solid-solid interface or a solid-liquid interface.

Based on this, embodiments of this application provide a photovoltaic inverter and a power apparatus, to implement direct-cooling heat dissipation of a power module, thereby improving heat dissipation efficiency of the photovoltaic inverter.

To make the objectives, technical solutions, and advantages of this application clearer, the following further describes this application in detail with reference to accompanying drawings.

Terms used in the following embodiments are merely intended to describe specific embodiments, but are not intended to limit this application. The terms "one", "a", "the", "the foregoing", "this", and "the one" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to the embodiment. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

As shown in FIG. 2, an embodiment of this application provides a photovoltaic inverter 10. The photovoltaic inverter 10 includes a heat sink 1 and a power module 2. There are, for example, a plurality of power modules 2, and the plurality of power modules 2 are arranged in a rectangular array manner. The heat sink 1 is configured to dissipate heat for the plurality of power modules 2. In FIG. 1, six power modules 2 are disposed, and are arranged in a matrix arrangement manner of two rows and three columns. The power module 2 specifically includes a substrate 21 and a power device 22 disposed on the substrate 21. The substrate 21 may implement functions such as electrical connection, protection, support, heat dissipation, and assembling for the power device 22, and can implement multi-pin configuration, to reduce a size of a packaged product, improve electrical performance and heat dissipation, and achieve an ultra-high density or multi-chip modularization. The substrate 21 of the power module 2 is fastened to the heat sink 1, and the power device 22 is located on a side that is of the substrate 21 and that faces away from the heat sink 1. When a plurality of power modules 2 are disposed, the plurality of power modules 2 are spaced apart, so that heat dissipation may be dispersedly performed, thereby improving heat dissipation uniformity.

It should be understood that, in the structure shown in FIG. 2, each power module 2 includes a substrate 21 and one power device 2 disposed on the substrate 21. Possibly, a plurality of power devices 22 may alternatively be disposed on one substrate 21. Therefore, a correspondence between a quantity of substrates 21 and a quantity of power devices 22 is not limited in this embodiment of this application.

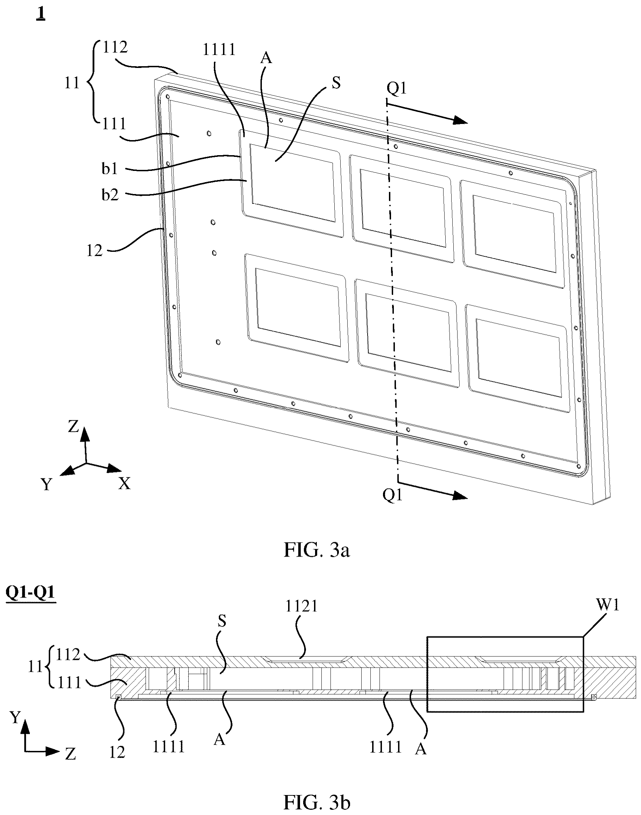

FIG. 3a shows a structure of the heat sink 1. The heat sink 1 includes an enclosure 11, and the enclosure 11 specifically includes a bottom case 111 and a top case 112. It is specified that a length direction of the enclosure 11 is a first direction X, a thickness direction of the enclosure 11 is a second direction Y, and a height direction of the enclosure 11 is a third direction Z. As shown in FIG. 3a, along the second direction Y, the bottom case 111 and the top case 112 are disposed opposite to each other and enclose a heat dissipation cavity S. The heat dissipation cavity S is a cavity, and may be configured to accommodate a cooling medium such as water or oil. During working, the cooling medium such as water or oil may be circulated into the heat dissipation cavity S. The cooling medium may absorb heat of the power module 2 and flow away, thereby implementing heat dissipation. The bottom case 111 includes a first groove 1111, and the first groove 1111 includes a groove side wall b1 and a groove bottom b2. For example, six first grooves 1111 are disposed in the bottom case 111. The first groove 1111 is configured to correspondingly fasten the power module 2. Certainly, "configured to correspondingly fasten the power module" herein includes that the power module 2 is directly fastened in the first groove 1111, and also includes that the power module 2 is fastened in the first groove 1111 by using another structure. Therefore, an orthographic projection of the power module 2 on the bottom case 111 is located in an orthographic projection range of the first groove 1111 on the bottom case 111.

Along the first direction X, three columns of first grooves 1111 are disposed. Along the third direction Z, two rows of first grooves 1111 are disposed. One window A is disposed at a groove bottom b2 of each first groove 1111. The window A penetrates the bottom case 111, so that the heat dissipation cavity S communicates with the outside through the window A. In the photovoltaic inverter 10, the substrate 21 of the power module 2 may be mounted in the first groove 1111, so that the substrate 21 may be in contact with the cooling medium in the heat dissipation cavity S through the window A. The cooling medium may absorb, through the substrate 21, heat emitted by the power device 22 on the substrate power module 2. When the substrate 21 is mounted in the first groove 1111, the window A may be blocked, so that the heat dissipation cavity S is relatively closed space, thereby facilitating filling and flowing of the cooling medium.

It should be understood that, when a plurality of power modules 2 are disposed, corresponding to the power modules 2, a plurality of windows A may be disposed on the bottom case 111, and the plurality of power modules 2 are in a one-to-one correspondence with the plurality of windows A. Therefore, the substrate 21 of each power module 2 may be in contact with the cooling medium in the heat dissipation cavity S through a corresponding window A, thereby improving heat dissipation uniformity.

To facilitate mounting of the heat sink 1, a sealing rubber ring 12 may be disposed on a surface that is of the bottom case 111 and that faces away from the top case 112. The sealing rubber ring 12 is disposed around an edge of the surface that is of the bottom case 111 and that faces away from the top case 112, and the plurality of first grooves 1111 are located in a range surrounded by the sealing rubber ring 12. Herein, examples of the first groove 1111 and the window A are rectangles. A quantity of windows A is the same as a quantity of power modules 2, and each window A may correspond to one power module 2.

A diagram of a cross-sectional structure shown in FIG. 3b may be obtained by sectioning the heat sink 1 along a plane in which Q1-Q1 in FIG. 3a is located. The plane in which Q1-Q1 is located is perpendicular to the first direction X, that is, the plane in which Q1-Q1 is located is parallel to the second direction Y and the third direction Z. As shown in FIG. 3b, the bottom case 111 is connected to the top case 112 along the second direction Y, and the foregoing heat dissipation cavity S is formed between the bottom case 111 and the top case 112. A second groove 1121 is disposed on a surface that is of the top case 112 and that faces away from the bottom case 111. The second groove 1121 may reduce a weight of the top case 112, thereby reducing mass of the enclosure 11.

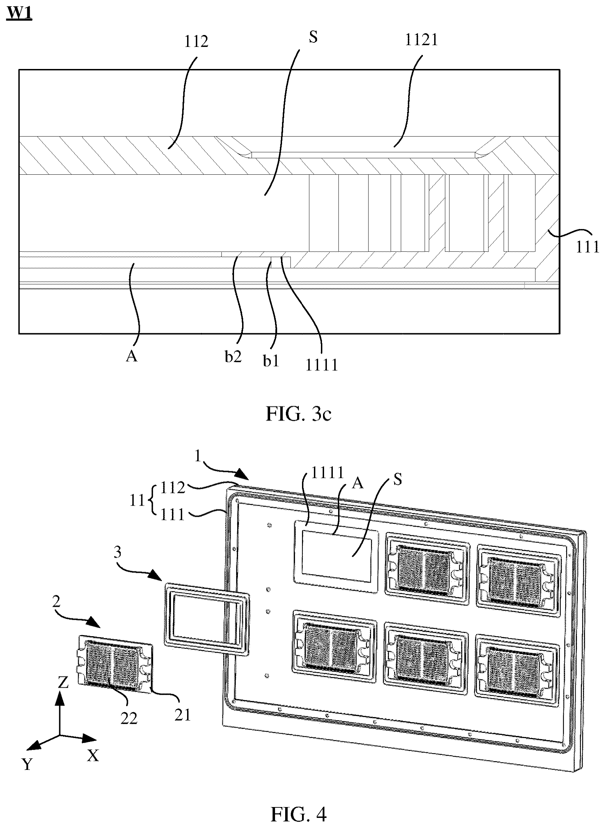

Further, with reference to an enlarged view that is of W1 in FIG. 3b and that is shown in FIG. 3c, the first groove 1111 is disposed on the surface that is of the bottom case 111 and that faces away from the top case 112. The window A is disposed at the groove bottom b2 of the first groove 1111, and the window A penetrates the bottom case 111. The second groove 1121 is disposed on the surface that is of the top case 112 and that faces away from the bottom case 111. A cross section of the second groove 1121 is trapezoidal. Specifically, a side wall of the second groove 1121 is inclined, so that a size of an opening of the second groove 1121 is greater than a size of a bottom of the second groove 1121.

With reference to the structure of the second groove 1121 and the structure of the window A that are shown in FIG. 3b and FIG. 3c, for the entire case 11, both the structure of the second groove 1121 and the structure of the window A may reduce strength stability of the enclosure 11 at corresponding positions. The second groove 1121 and the window A may be spaced apart along a direction perpendicular to the third direction Z, so that an orthographic projection of the window A on the top case 112 does not overlap an orthographic projection of the second groove 1121 on the top case 112. Specifically, the second groove 1121 may be disposed between two adjacent windows A, to ensure that the strength and the stability of the enclosure 11 meet a process requirement and a structure requirement.

During working, heat exchange may be implemented between the cooling medium in the heat sink 1 and an external structure such as a condenser, so that heat of the power module 2 may be conducted away to dissipate heat for the power module 2. In a process in which the heat of the power module 2 is transferred to the cooling medium, no other medium participates, and direct-cooling heat dissipation of the power module 2 may be implemented. It may be learned from the above that thermal resistance in a heat dissipation link of the photovoltaic inverter 10 is relatively small, so that heat conduction efficiency can be improved, thereby improving heat dissipation efficiency. Because the photovoltaic inverter 10 has high heat dissipation efficiency, the photovoltaic inverter 10 may have better performance in terms of power density, and meet a requirement of scientific and technological development for a higher power density of the photovoltaic inverter 10.

To mount the power module 2 to the bottom case 111 of the heat sink 1, an annular adapter enclosure frame 3 may be used between the power module 2 and the heat sink 1. As shown in an exploded view of the photovoltaic inverter 10 in FIG. 4, the annular adapter enclosure frame 3 is disposed between the power module 2 and the heat sink 1. A surface that is of the annular adapter enclosure frame 3 and that faces the heat sink 1 is connected to the bottom case 111, and a surface that is of the annular adapter enclosure frame 3 and that faces the power module 2 is connected to the substrate 21. Specifically, the substrate 21 of the power module 2 may be fastened to an inner edge of the annular adapter enclosure frame 3, and an outer edge of the annular adapter enclosure frame 3 is fastened to the bottom case 111. A size of the outer edge of the annular adapter enclosure frame 3 adapts to a size of the first groove 111. Based on a structure of the annular adapter enclosure frame 3, the inner edge of the annular adapter enclosure frame 3 is an inner side of a ring, and the outer edge of the annular adapter enclosure frame 3 is an outer side of the ring.

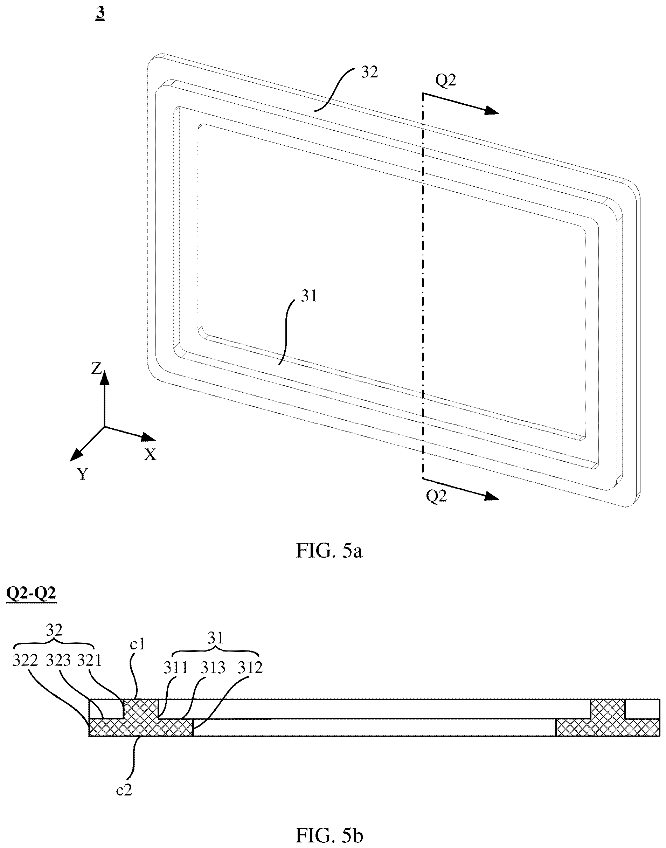

FIG. 5a shows the structure of the annular adapter enclosure frame 3. The annular adapter enclosure frame 3 is an annular rectangle. The annular adapter enclosure frame 3 has the inner edge and the outer edge along a direction perpendicular to the second direction Y. Both the inner edge and the outer edge are in a groove shape. FIG. 5b is a diagram of a cross-sectional structure of Q2-Q2 in FIG. 5a. A plane in which Q2-Q2 is located is perpendicular to the first direction X, that is, the plane in which Q2-Q2 is located is parallel to the second direction Y and the third direction Z. The annular adapter enclosure frame 3 has a surface c1 that faces away from the heat sink 1 and a surface c2 that faces the heat sink 1. A first stepped surface 31 is disposed on the surface c1 that is of the annular adapter enclosure frame 3 and that faces away from the heat sink 1, and the first stepped surface 31 is located on an inner edge side. Specifically, the first stepped surface 31 includes a first inner wall 311, a second inner wall 312, and a first connection wall 313 connected between the first inner wall 311 and the second inner wall 312. The first stepped surface 31 may be configured to mount the substrate 21 of the power module 2. A second stepped surface 32 is disposed on the surface c1 that is of the annular adapter enclosure frame 3 and that faces away from the heat sink 1, and the second stepped surface 32 is located on an outer edge side. The second stepped surface 32 is disposed on the outer edge of the annular adapter enclosure frame 3. The second stepped surface 32 includes a first outer wall 321, a second outer wall 322, and a second connection wall 323 connected between the first outer wall 321 and the second outer wall 322. The second stepped surface 32 may be configured to match the bottom case 111 of the heat sink 1.

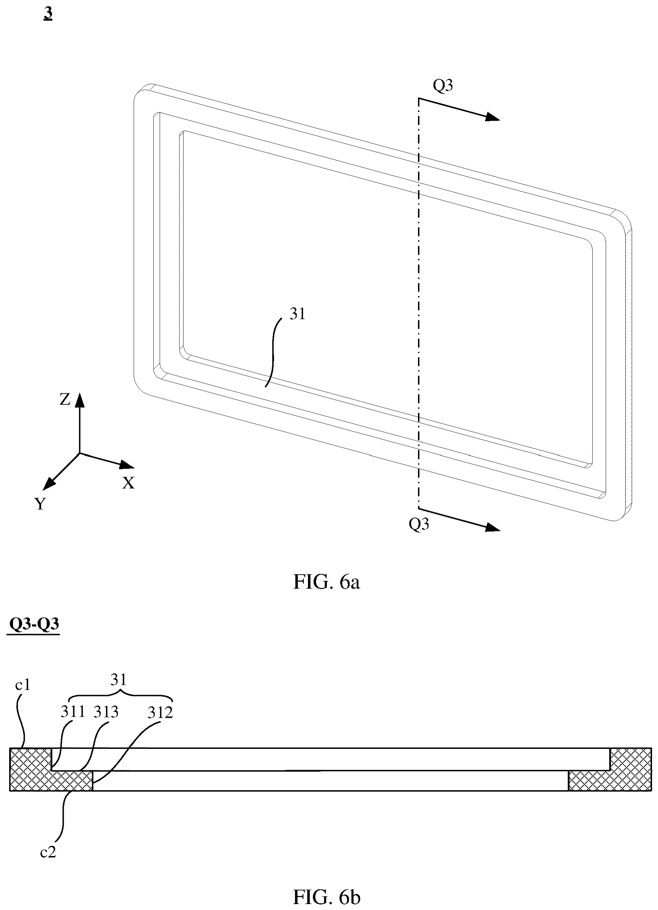

FIG. 6a shows a structure of another annular adapter enclosure frame 3. FIG. 6b shows a diagram of a cross-sectional structure of Q3-Q3 in FIG. 6a. A first stepped surface 31 is disposed only on an inner edge side of the annular adapter enclosure frame 3, and the first stepped surface 31 may be configured to mount the substrate 21 of the power module 2.

The following uses the annular adapter enclosure frame 3 shown in FIG. 5a and FIG. 5b as an example to describe the photovoltaic inverter 10 provided in this embodiment of this application.

For example, when the substrate 21 of the power module 2 is fastened to the bottom case 111 by using the annular adapter enclosure frame 3, the annular adapter enclosure frame 3 is fastened in the first groove 1111. An orthographic projection of the substrate 21 on the bottom case 111 overlaps an orthographic projection of the window A on the bottom case 111. Specifically, the orthographic projection of the substrate 21 on the bottom case 111 may cover the orthographic projection of the window A on the bottom case 111. Alternatively, the orthographic projection of the substrate 21 on the bottom case 111 may at least partially overlap the orthographic projection of the window A on the bottom case 111. The substrate 21 of the power module 2 and the annular adapter enclosure frame 3 may cooperate to cover and block the window A, so that the heat dissipation cavity S is a relatively closed cavity, which is convenient for accommodating the cooling medium. Herein, a surface that is of the bottom case 111 and that faces the power module 2 is used as a reference, and an orthographic projection is a projection of another structure projected onto the bottom case 111 along a direction perpendicular to the surface. Certainly, the surface that is of the bottom case 111 and that faces the power module 2 may be a plane. Based on process manufacturing or structure design, the surface that is of the bottom case 111 and that faces the power module 2 may alternatively not be a plane.

When the substrate 21 of the power module 2 is mounted to the bottom case 111 by using the annular adapter enclosure frame 3, the substrate 21 may be directly in contact with the cooling medium in the heat dissipation cavity S through the window A, thereby implementing direct-cooling heat dissipation.

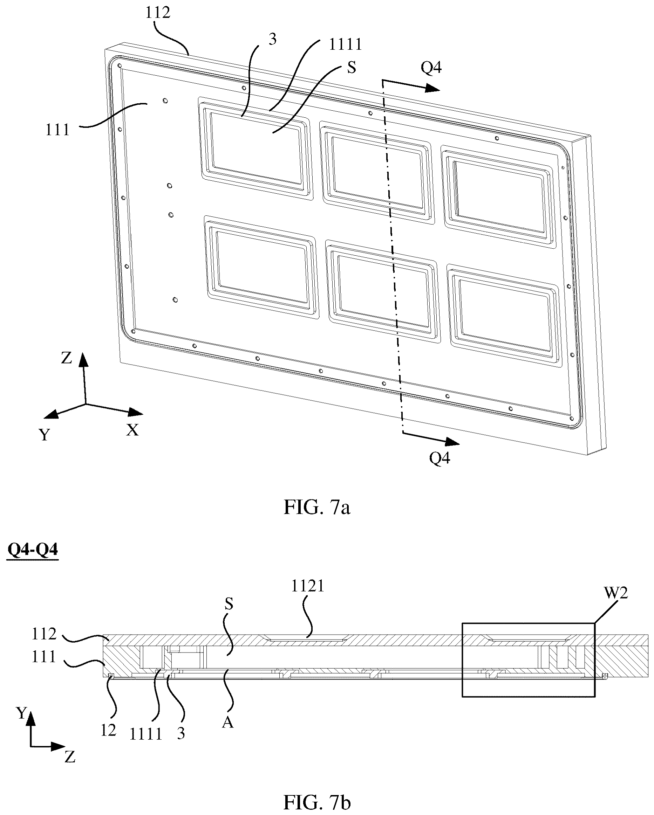

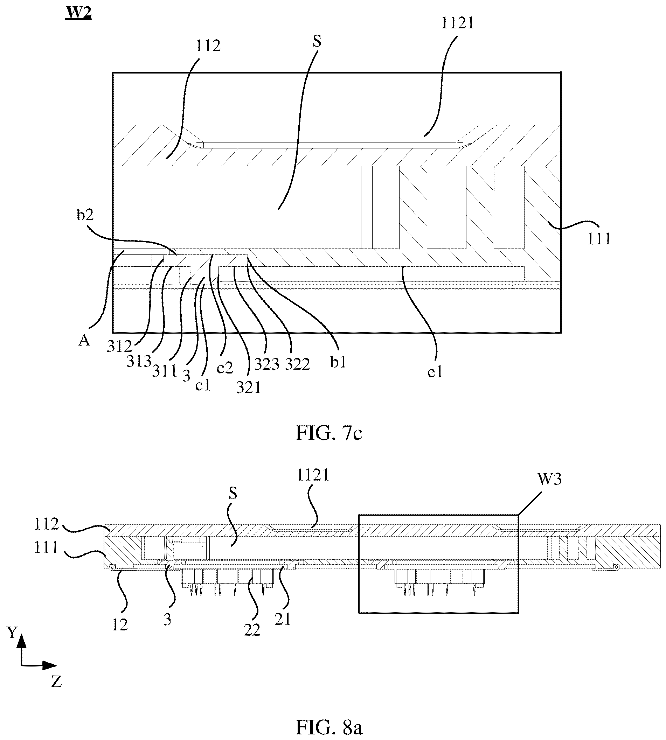

FIG. 7a shows a structure in which the annular adapter enclosure frame 3 is mounted to the bottom case 111. The annular adapter enclosure frame 3 may be accommodated in the first groove 1111. A diagram of a cross-sectional structure shown in FIG. 7b may be obtained by sectioning the heat sink 1 and the annular adapter enclosure frame 3 along a plane in which Q4-Q4 in FIG. 7a is located. FIG. 7c shows an enlarged view of W2 in FIG. 5b. The plane in which Q4-Q4 is located is perpendicular to the first direction X, that is, the plane in which Q4-Q4 is located is parallel to the second direction Y and the third direction Z. The surface c2 that is of the annular adapter enclosure frame 3 and that faces the heat sink 1 is in contact with and coplanar with the groove bottom b2, so that the surface that is of the annular adapter enclosure frame 3 and that faces the heat sink 1 can abut against the groove bottom b2. The second stepped surface 32 of the annular adapter enclosure frame 3 can match the groove side wall b1. Specifically, the second connection wall 323 of the second stepped surface 32 is kept in a same plane as a surface e1 that is of the heat sink 1 and that faces the power module 2, so that a joint between the annular adapter enclosure frame 3 and the bottom case 111 is kept flat. The first stepped surface 31 on the inner edge of the annular adapter enclosure frame 3 is configured to fasten the substrate 21 of the power module 2. The first stepped surface 31 and the second stepped surface 32 of the annular adapter enclosure frame 3 can enable the surface c1 that is of the annular adapter enclosure frame 3 and that faces away from the heat sink 1 to protrude from the surface e1 that is of the heat sink 1 and that faces the power module 2. It may be considered that the annular adapter enclosure frame 3 surrounds the window A and is fastened in the first groove 1111.

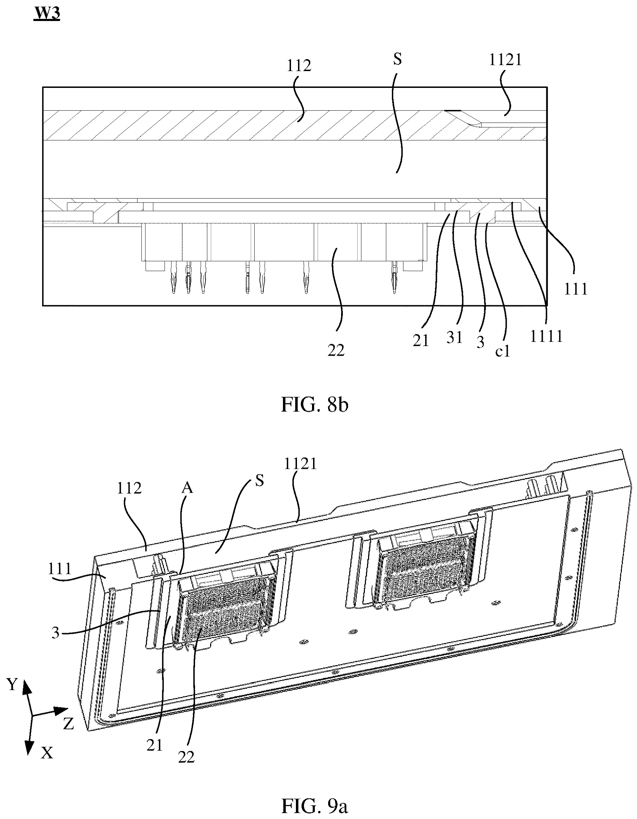

FIG. 8a shows a diagram of a cross-sectional structure in which the power module 2 is mounted to the annular adapter enclosure frame 3. FIG. 8b shows an enlarged view of W3 in FIG. 8a. Along a direction perpendicular to the first direction X, the outer edge of the annular adapter enclosure frame 3 is fastened in the first groove 1111, the substrate 21 of the power module 2 is fastened to the first stepped surface 31 on the inner edge of the annular adapter enclosure frame 3, and a surface that is of the substrate 21 and that faces away from the heat sink 1 may be kept coplanar with a surface that is of the annular adapter enclosure frame 3 and that faces away from the heat sink 1, so that a joint between the substrate 21 and the bottom case 111 is kept flat. The annular adapter enclosure frame 3 is located in the first groove 1111, so that the substrate 21 is closer to the heat dissipation cavity S, thereby improving heat dissipation effect.

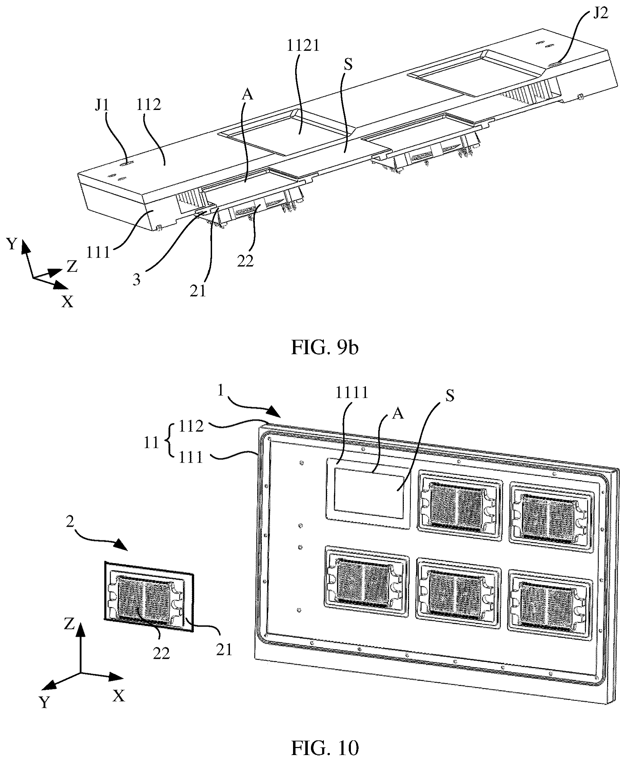

As shown in FIG. 9a and FIG. 9b, the power module 2 is fastened to the heat sink 1 by using the annular adapter enclosure frame 3. The substrate 21 of the power module 2 may be in contact with the cooling medium in the heat dissipation cavity S of the heat sink 1 through the window A, so that the circulating cooling medium may dissipate heat for the power device 22 through the substrate 21. As shown in FIG. 9b, a liquid inlet J1 and a liquid outlet J2 that are configured to circulate liquid to the heat sink S are further disposed on the top case 112 of the heat sink 1. The liquid inlet J1 and the liquid outlet J2 separately penetrate the top case 112, so that the heat dissipation cavity S communicates with the outside. The cooling medium with a relatively low temperature may be transferred to the heat dissipation cavity S through the liquid inlet J1. The cooling medium with a relatively low temperature may be in contact with the substrate 21 of the power module 2 through the window A, and therefore absorb, through the substrate 21, heat emitted by the power device 22. After absorbing heat, the cooling medium has a higher temperature, and may be discharged through the liquid outlet J2. During working, an external circulating cooling device forms a circulation loop by using the liquid inlet J1 and the liquid outlet J2, so that the cooling medium in the heat dissipation cavity S may be kept in contact with the substrate 21 to take away heat of the power module 2, thereby implementing cooling and heat dissipation for the power module 2. It should be understood that positions and functions of the liquid inlet J1 and the liquid outlet J2 are merely examples, provided that one of the liquid inlet J1 and the liquid outlet J2 is used for liquid entering and the other is used for liquid discharging.

In FIG. 9a and FIG. 9b, the second groove 1121 disposed on the surface that is of the top case 112 and that faces away from the bottom case 111 and the power module 2 fastened to the surface that is of the bottom case 111 and that faces away from the top case 112 are spaced apart, so that structural strength and stability of the heat sink 1 are not affected when a purpose of reducing a weight is achieved.

With reference to the foregoing embodiment, the power module 2 may be fastened to the annular adapter enclosure frame 3 in a welding manner, and the heat sink 1 may also be fastened to the annular adapter enclosure frame 3 in a welding manner. Welding is a manufacturing process of bonding metals or other thermoplastic materials through heating, a high temperature, or high pressure. The thermoplastic materials include but are not limited to plastic.

In this embodiment of this application, the power device 22 of the power module 2 has a limited withstand temperature. Specifically, the power device 22 may ensure normal working at a temperature not higher than a temperature threshold. When the temperature of the power device 22 is greater than or equal to the temperature threshold, the power device 22 may be damaged or fail. For example, the temperature threshold for the power device 22 in this application to work normally is 200°C. When the temperature of the power device 22 is less than 200°C, the power device 22 may work normally. When the temperature of the power device 22 is greater than 200°C, the power device 22 may be damaged or fail. Therefore, when the substrate 21 is welded to the bottom case 111 by using the annular adapter enclosure frame 3, it needs to be ensured that the temperature of the power device 22 does not exceed 200°C.

In the embodiment in which the power module 2 is fastened to the heat sink 1 by using the annular adapter enclosure frame 3, a material of the substrate 21 of the power module 2 includes copper or a copper alloy, and a material of the bottom case 111 includes aluminum or an aluminum alloy. To weld the power module 2, welding of the substrate 21 of the power module 2 to the annular adapter enclosure frame 3 may be performed separately from welding of the annular adapter enclosure frame 3 to the bottom case 111.

In a feasible embodiment, the annular adapter enclosure frame 3 is made of a copper or stainless steel material. Specifically, a material of the annular adapter enclosure frame 3 may be pure copper. The annular adapter enclosure frame 3 may be first welded to the window A on the bottom case 111, and a welding manner may include but is not limited to laser welding, brazing, friction stir welding, or the like. Then, the substrate 21 of the power module 2 is welded to the adapter enclosure frame 3, and a welding manner may include but is not limited to laser welding. In laser welding, heat input may be reduced to a minimum required amount, a metallographic change range of a heat-affected zone is small, and deformation caused by heat conduction is also a minimum. Therefore, when the substrate 21 is welded to the adapter enclosure frame 3 through laser welding, the power device 22 on the substrate 21 suffers little heat radiation, so that the power device 22 is kept at a relatively low temperature, thereby avoiding damage or failure of the power device 22 due to a temperature rise to the temperature threshold.

In another possible embodiment, the annular adapter enclosure frame 3 is made of a copper-aluminum composite material. The copper-aluminum composite material herein includes a first frame portion made of a pure copper material and a second frame portion made of a pure aluminum material. The first frame portion and the second frame portion are welded together in a manner of cold rolling, hot rolling, explosive cladding, or the like. The first frame portion is configured to connect to the substrate 21 of the power module 2, and the second frame portion is configured to connect to the bottom case 111 of the heat sink 1.

It should be understood that, by using this welding manner and this welding structure, a technical problem that failure of the power module 2 is caused by a very high temperature during one-time copper-aluminum welding may be avoided. In addition, a problem that failure of the power module 2 is caused by excessive deformation under stress during one-time copper-aluminum welding may also be avoided.

As shown in another exploded view of the photovoltaic inverter 10 in FIG. 10, the substrate 21 of the power module 2 is directly fastened to the bottom case 111 of the heat sink 1.

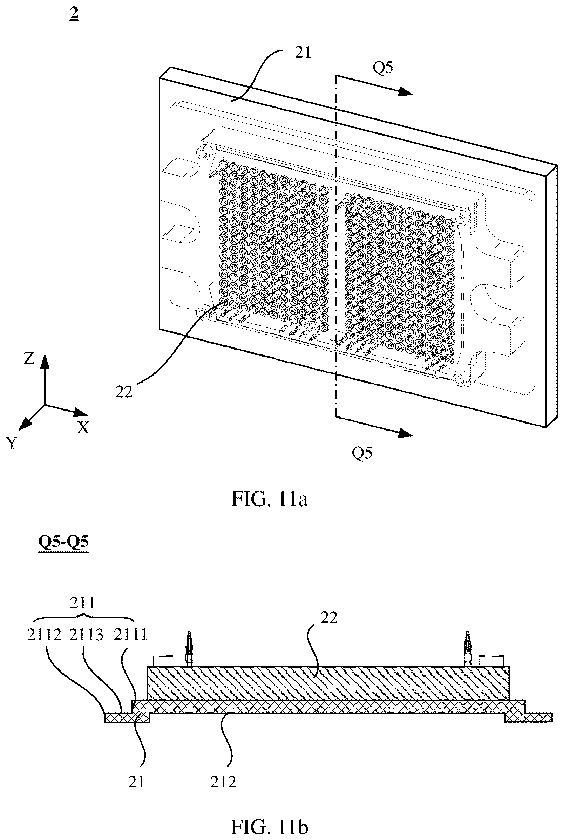

FIG. 11a shows a structure of the power module 2. A diagram of a cross-sectional structure shown in FIG. 11b may be obtained by sectioning the power module 2 along a plane in which Q5-Q5 in FIG. 11a is located. The plane in which Q5-Q5 is located is perpendicular to the first direction X, that is, the plane in which Q5-Q5 is located is parallel to the second direction Y and the third direction Z. A third stepped surface 211 is formed on an outer edge of the substrate 21. The third stepped surface 211 includes a first riser surface 2111, a second riser surface 2111, and a third connection surface 2113 connected between the first riser surface 2111 and the second riser surface 2112. The power device 22 is disposed on a surface that is of the substrate 21 and that faces away from the heat sink 1. Thinning processing is performed on a surface that is of the substrate 21 and that faces away from the power device 22, to form a third groove 212. Disposing of the third groove 212 may not only reduce a weight of the substrate 21, but also reduce a thickness of the substrate 21 at a position at which the power device 22 is disposed, so that heat emitted by the power device 22 can be exchanged with the cooling medium through the substrate 21.

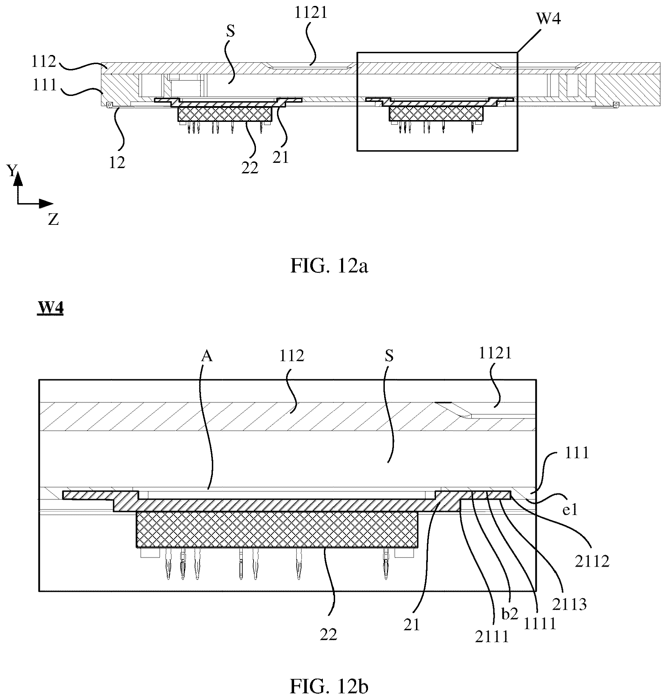

For a structure in which the power module 2 is fastened to the bottom case 111 of the heat sink 1, refer to FIG. 12a. FIG. 12b shows an enlarged view of W4 in FIG. 12a. The substrate 21 of the power module 2 is fastened to the first groove 1111, and a surface that is of the substrate 21 and that faces the heat sink 1 is in contact with and kept coplanar with the groove bottom b2. The third connection surface 2113 on the substrate 21 is kept flush with the surface e1 that is of the bottom case 111 and that faces away from the heat dissipation cavity S, so that the joint between the substrate 21 and the bottom case 111 is kept flat. A projection of the substrate 21 on the bottom case 111 covers a projection of the window A on the bottom case 111. When the substrate 21 is fastened to the bottom case 111, the substrate 21 may block the window A. The cooling medium in the heat dissipation cavity S may be in contact with the substrate 21 through the window A, thereby implementing direct-cooling heat dissipation of the power module 2.

In the embodiment in which the power module 2 is directly fastened to the bottom case 111 of the heat sink 1, the substrate 21 of the power module 2 may also be fastened to the bottom case 111 in a welding manner. In view of the limited withstand temperature of the power device 22 of the power module 2, a material of the substrate 21 of the power module 2 may include a copper-aluminum composite material or a copper-steel composite material, and a material of the bottom case 111 may include aluminum or an aluminum alloy. During manufacturing, the power device 22 may be directly integrated into the bottom case 111, and then the substrate 21 may be welded to the adapter enclosure frame 3. A welding manner may include but is not limited to laser welding. In this way, the power device 22 is kept at a relatively low temperature during welding, thereby avoiding damage or failure of the power device 22 due to a temperature rise to the temperature threshold.

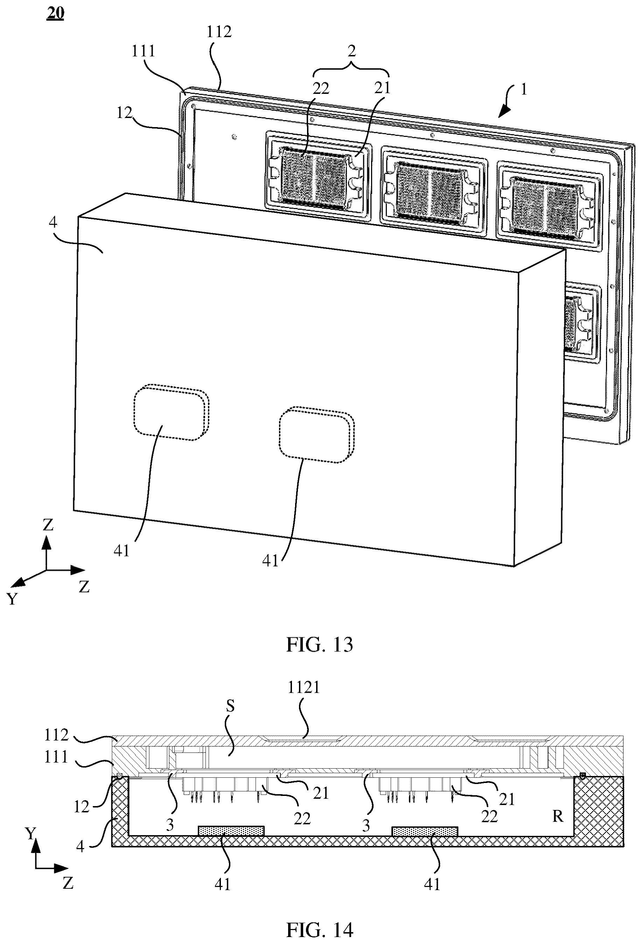

An embodiment of this application further provides a power apparatus 20. As shown in FIG. 13, the power apparatus 20 includes a power conversion circuit, a housing 4, and a heat sink 1. The power conversion circuit includes a plurality of power modules 2 and a plurality of components 41. The heat sink 1 includes a bottom case 111 and a top case 112 that are disposed opposite to each other, and the bottom case 111 and the top case 112 enclose a heat dissipation cavity S. The plurality of power modules 2 may be fastened to the bottom case 111 of the heat sink 1, and be in contact with a cooling medium in the heat dissipation cavity S through a window on the bottom case 111, thereby implementing direct-cooling heat dissipation. For a structure between the heat sink 1 and the power module 2, refer to the description in the foregoing embodiment. Details are not described herein again. The plurality of components 41 are fastened to a side that is of the housing 4 and that faces the heat sink 1, and two components 41 are shown by using dashed lines due to being hidden by the housing 4.

As shown in FIG. 14, the housing 4 is fastened to the bottom case 111 of the heat sink 1, an accommodating cavity R can be formed between the housing 4 and the bottom case 111, and the power conversion circuit is located in the accommodating cavity R. A rubber ring 12 on the bottom case 111 is located between the housing 4 and the bottom case 111, and can play a good sealing role.

There may be a plurality of types of power apparatuses 20 provided in this embodiment of this application, and the power apparatus 20 may be specifically a photovoltaic inverter, an in-vehicle power unit, a power conversion module, or the like. For different types of power apparatuses 20, the power conversion circuit may be implemented in a plurality of manners.

In some possible implementations, the power conversion circuit includes six power modules 2, and the plurality of power modules 2 can form a three-phase or single-phase bridge circuit. Alternatively, the power conversion circuit includes four power modules 2, and the plurality of power modules 2 can form a single-phase bridge circuit.

In some other possible implementations, the power conversion circuit includes a plurality of power modules 2, and a power device 22 of each power module 2 is electrically connected to a power device 22 of another power module 2, or a power device 22 of each power module 2 is electrically connected to at least one component 41.

According to the photovoltaic inverter 10 and the process apparatus 20 provided in embodiments of this application, the power module 2 may be in contact with the cooling medium in the heat dissipation cavity S through the window A on the heat sink 1, thereby implementing direct-cooling heat dissipation. In this structure, a thermally conductive intermediary between a heat source and a heat dissipation structure is not required, thereby improving heat conduction efficiency and optimizing heat dissipation effect. In addition, a connection structure between the power module 2 and the heat sink 1 is simple, material costs are low, there is a good application prospect, and the structure may be widely applied to a scenario with the power module 2 and the heat sink 1.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A photovoltaic inverter (10), comprising a heat sink (1) and a power module (2), wherein the heat sink (1) comprises a bottom case (111) and a top case (112) that are disposed opposite to each other, the bottom case (111) and the top case (112) enclose a heat dissipation cavity (S), the heat dissipation cavity (S) is configured to accommodate a cooling medium, and the cooling medium is configured to dissipate heat for the power module, wherein
the bottom case (111) comprises a window (A), the window (A) penetrates the bottom case (111), the power module (2) is fastened to the bottom case (111), an orthographic projection of the power module (2) on the bottom case (111) overlaps an orthographic projection of the window (A) on the bottom case (111), and the power module (2) is in contact with the cooling medium through the window (A).

2. The photovoltaic inverter (10) according to claim 1, wherein the power module (2) comprises a substrate (21) and a power device (22), wherein
the power device (22) is fastened to the substrate (21), and the substrate (21) is configured to be fastened to the bottom case (111).

3. The photovoltaic inverter (10) according to claim 1 or 2, wherein an orthographic projection of the power device (22) on the substrate (21) is located on a surface that is of the substrate (21) and that faces away from the heat sink (1).

4. The photovoltaic inverter (10) according to any one of claims 1 to 3, wherein the photovoltaic inverter comprises an annular adapter enclosure frame (3), a surface that is of the annular adapter enclosure frame (3) and that faces the heat dissipation cavity (S) is configured to be fastened to the bottom case (111), and the other surface that is of the annular adapter enclosure frame (3) and that faces away from the heat dissipation cavity (S) is configured to be fastened to the power module (2).

5. The photovoltaic inverter (10) according to claim 4, wherein a material of the annular adapter enclosure frame (3) comprises copper, stainless steel, or a copper-aluminum composite material, a material of the substrate (21) comprises copper or a copper alloy, a material of the bottom case (111) comprises aluminum or an aluminum alloy, the annular adapter enclosure frame (3) is welded to the power module (2), and the annular adapter enclosure frame (3) is welded to a surface that is of the an enclosure (11) and on which the window (A) is disposed.

6. The photovoltaic inverter (10) according to claim 4, wherein the orthographic projection of the window (A) on the bottom case (111) is located in an orthographic projection range of an outer edge of the annular adapter enclosure frame (3) on the bottom case (111), and an orthographic projection of the substrate (21) on the bottom case (111) covers an orthographic projection of an inner edge of the annular adapter enclosure frame (3) on the bottom case (111).

7. The photovoltaic inverter (10) according to claim 4, wherein a first stepped surface (31) is disposed on a surface that is of the annular adapter enclosure frame (3) and that faces away from the heat sink (1), and the first stepped surface (31) is located on an inner edge side of the annular adapter enclosure frame (3); the first stepped surface (31) comprises a first inner wall (311), a second inner wall (312), and a first connection wall (313) connected between the first inner wall (311) and the second inner wall (312); a projection of the second inner wall (312) on the bottom case (111) is located in a projection range of the first inner wall (311) on the bottom case (111); and the substrate (21) is welded to the first connection wall (313).

8. The photovoltaic inverter (10) according to claim 5, wherein a second stepped surface (32) is disposed on a surface that is of the adapter enclosure frame (3) and that faces away from the heat sink (1), and the first stepped surface (31) is located on an outer edge side of the annular adapter enclosure frame (3); the second stepped surface (32) comprises a first outer wall (321), a second outer wall (322), and a third connection wall (323) connected between the first outer wall (321) and the second outer wall (322); a projection of the second outer wall (322) on the enclosure (11) is located in a projection range of the first outer wall (321) on the bottom case (111); and the third connection wall (323) is coplanar with a surface that is of the bottom case (111) and that faces away from the heat dissipation cavity (S).

9. The photovoltaic inverter (10) according to claim 2, wherein a material of the substrate (21) comprises a copper-aluminum composite material or a copper-steel composite material, a material of the bottom case (111) comprises aluminum or an aluminum alloy, and the substrate (21) is welded to the bottom case (111).

10. The photovoltaic inverter (10) according to claim 9, wherein a projection of the substrate (21) on the bottom case (111) covers a projection of the window (A) on the bottom case (111).

11. The photovoltaic inverter (10) according to any one of claims 1 to 10, wherein the photovoltaic inverter (10) comprises a plurality of power modules (2), and the bottom case (111) comprises a plurality of windows (A), wherein
the plurality of windows are spaced apart; and
the plurality of the power modules (2) are in a one-to-one correspondence with the plurality of the windows (A).

12. The photovoltaic inverter (10) according to any one of claims 1 to 11, wherein a second groove (1121) is disposed on a surface that is of the top case (112) and that faces away from the heat dissipation cavity (S), and an orthographic projection of the second groove (1121) on the top case (111) is located between orthographic projections of two adjacent power modules (2) on the top case (111).

13. The photovoltaic inverter (10) according to any one of claims 1 to 12, wherein a liquid inlet (1121) and a liquid outlet (1122) are disposed on the top case (112), and the liquid inlet (1121) and the liquid outlet (1122) separately penetrate the top case (112).

14. The photovoltaic inverter (10) according to any one of claims 1 to 13, wherein the bottom case (111) comprises a first groove, the first groove (1111) comprises a groove side wall (b1) and a groove bottom (b2), and the window (A) is disposed at the groove bottom (b2); and the orthographic projection of the power module (2) on the bottom case (111) is located in an orthographic projection range of the first groove (1111) on the bottom case (111).

15. A power apparatus, comprising a power conversion circuit, a housing (4), and a heat sink (1), wherein the power conversion circuit comprises a plurality of power modules (2) and a plurality of components (41), wherein
the housing (4) and the heat sink (1) enclose an accommodating cavity (R), and the accommodating cavity (R) is configured to accommodate the power conversion circuit;
the heat sink (1) comprises a bottom case (111) and a top case (112) that are disposed opposite to each other, the bottom case (111) and the top case (112) enclose a heat dissipation cavity (S), the heat dissipation cavity (S) is configured to accommodate a cooling medium, a plurality of windows (A) are disposed on the bottom case (111), and each window (A) penetrates the bottom case (111); and
the plurality of power modules (2) are fastened to the bottom case (111), and the plurality of power modules (2) are in contact with the cooling medium through the plurality of windows (A) that are in a one-to-one correspondence with the plurality of power modules (2).
